# EUROPEAN PATENT APPLICATION

(11) **EP 4 468 824 A1**
(43) Date of publication of application: **27.11.2024**
(21) Application number: 24177980.0
(22) Date of filing: 24.05.2024
(51) Int. Cl.: H05B 6/76

(54) **COOKING APPLIANCE**

(30) Priority: 26.05.2023 KR 20230068505
(71) Applicant: LG Electronics Inc., Yeongdeungpo-gu Seoul 07336 (KR)
(72) Inventor: SIM, Sunghun, 08592 Seoul (KR); YANG, Jaekyung, 08592 Seoul (KR); HA, Junghyeong, 08592 Seoul (KR); SHIN, Myeongjun, 08592 Seoul (KR)
(74) Representative: Vossius & Partner Patentanwälte Rechtsanwälte mbB

(57) **Abstract**

A cooking appliance is provided. The cooking appliance (1) includes a cooking chamber (520) where a load is located, a front panel (610) located at one end of the cooking chamber and having a bent portion, and a door (620) having a structure that shields heat and electromagnetic waves generated in the cooking chamber, wherein the door includes a door frame (1130) including a choke and a choke cover (1150), wherein a shielding member (830) is disposed between the front panel and the door, and wherein the shielding member is in contact with at least one surface of the front panel and the door.

## Description

### BACKGROUND

The present disclosure relates to a cooking appliance.

Various types of cooking appliances are used to heat food at home or in the restaurant. For example, various cooking appliances such as microwave ovens, induction heating type electric stoves, and grill heaters are used.

A microwave oven is a high-frequency heating type cooking appliance that uses molecules in a high-frequency electric field to vibrate violently and generate heat, allowing food to be heated evenly in a short period of time.

An induction heating type electric stove is a cooking appliance that heats an object to be heated by using electromagnetic induction. Specifically, when high-frequency power of a predetermined magnitude is applied to a coil, the induction heating type electric stove generates an eddy current in the object to be heated consisting of a metal component using a magnetic field generated around the coil to heat the object to be heated itself.

A grill heater is a cooking appliance that heats food by radiating or convecting infrared heat. Because the infrared heat penetrates through food, the food may be heated evenly as a whole.

In the case of a built-in combination oven, compared to a microwave oven, a door gap is 2-3 times larger. Therefore, according to the related art, a plurality of door chokes have been used to reliably shield electromagnetic wave leakage. This may cause problems in the manufacturing process and size management because the door becomes thicker or the structural configuration becomes more complex.

### SUMMARY

The present disclosure provides a cooking appliance including a door with a single door choke so as to block electromagnetic waves as well as heat.

The present disclosure provides a cooking appliance that achieves both heat and shielding through the structural design of a gasket and a door choke.

A cooking appliance according to an embodiment of the present disclosure may include a cooking chamber where a load is located, a front panel located at one end of the cooking chamber and having a bent portion, and a door having a structure that shields heat and electromagnetic waves generated in the cooking chamber, wherein the door includes a door frame including a choke and a choke cover, wherein a shielding member is disposed between the front panel and the door, and wherein the shielding member is in contact with at least one surface of the front panel and the door.

In the cooking appliance according to an embodiment of the present disclosure, the door frame may include a door gap protruding toward the cooking chamber.

In the cooking appliance according to an embodiment of the present disclosure, the shielding member may be formed of a circular, elastic material, and an outer circumference of the shielding member may be covered with a metal mesh.

In the cooking appliance according to an embodiment of the present disclosure, a height and a length of the door gap may be associated with at least one of a size or elasticity of the shielding member.

In the cooking appliance according to an embodiment of the present disclosure, a height and a length of the door gap may be determined considering at least one of heat or electromagnetic waves used to heat the load in the cooking chamber.

In the cooking appliance according to an embodiment of the present disclosure, the choke may include a choke piece that has at least one surface protruding to be exposed to the cooking chamber, form the door gap through a first bent portion, and accommodate the shielding member through second to fourth bent portions.

In the cooking appliance according to an embodiment of the present disclosure, the choke cover may be formed of an elastic material, may be disposed between the fourth bent portion of the choke piece and one surface of the front panel, and may be in contact with one surface of the shielding member to support the shielding member.

In the cooking appliance according to an embodiment of the present disclosure, a width between the fourth bent portion of the choke piece and one surface of the front panel may be smaller than the height of the door gap.

In the cooking appliance according to an embodiment of the present disclosure, the choke may further include a first choke base that is disposed between an outer circumferential surface of the choke piece, an outer surface of the choke cover, and a cover of the door, and has a space to receive and shield at least one of heat or electromagnetic waves passing through the choke cover.

In the cooking appliance according to an embodiment of the present disclosure, the first choke base may include a plurality of bent portions and may be formed to have an arbitrary angle such that heat and electromagnetic waves incident through the choke cover and the plurality of bent portions are reflected.

In the cooking appliance according to an embodiment of the present disclosure, the door may further include a second choke base that receives and shields at least one of heat or electromagnetic waves generated in the cooking chamber through glass disposed in front of the cooking chamber, and the second choke base may have a space formed by a plurality of bent portions so as to induce and reflect at least one of heat or electromagnetic waves incident on the space defined therein.

In the cooking appliance according to an embodiment of the present disclosure, the first choke base may be in contact with at least a portion of the second choke base.

In the cooking appliance according to an embodiment of the present disclosure, a periodic structure of the choke may be designed as a slat structure in which grooves are formed at regular intervals, and a length of the choke and a width of the slat may be modified according to a frequency of the electromagnetic waves.

A cooking appliance according to an embodiment of the present disclosure may include a cooking chamber where a load is located, a front panel located at one end of the cooking chamber and having a bent portion, and a door that shields heat and electromagnetic waves. The door may include a cover assembly door including a handle, an inner portion including a mesh plate for electromagnetic wave shielding at a rear surface of the cover assembly door, a frame assembly door including a choke structure for shielding electromagnetic waves on a rear surface of inner glass of a glass structure that is mounted on a rear surface of the inner portion and blocks heat, a gasket packing that is mounted on a rear surface of the frame assembly door and shields heat and electromagnetic wave leakage when the door is closed, and a choke cover that covers the gasket packing and has a slat shape.

### BRIEF DESCRIPTION OF THE DRAWINGS

FIG. 1 is a perspective view of a cooking appliance according to an embodiment of the present disclosure.
FIGS. 2 to 4 are control block diagrams of a cooking appliance according to an embodiment of the present disclosure.
FIG. 5 is a cross-sectional view of a cooking appliance according to an embodiment of the present disclosure.
FIG. 6 is a configuration diagram of a cooking chamber according to an embodiment of the present disclosure.
FIG. 7 is a diagram illustrating a door choke structure.
FIG. 8 is a diagram illustrating a door choke structure according to an embodiment of the present disclosure.
FIG. 9 is a diagram illustrating a front panel according to an embodiment of the present disclosure.
FIG. 10 is a diagram illustrating a slat according to an embodiment of the present disclosure.
FIGS. 11 and 12 are diagrams for describing a door structure or configuration according to an embodiment of the present disclosure.

### DETAILED DESCRIPTION OF THE EMBODIMENTS

Hereinafter, embodiments of the present disclosure will be described in detail with reference to the accompanying drawings. Throughout the drawings, the same reference numerals are used to indicate the same or similar components.

Hereinafter, a cooking appliance according to an embodiment of the present disclosure will be described.

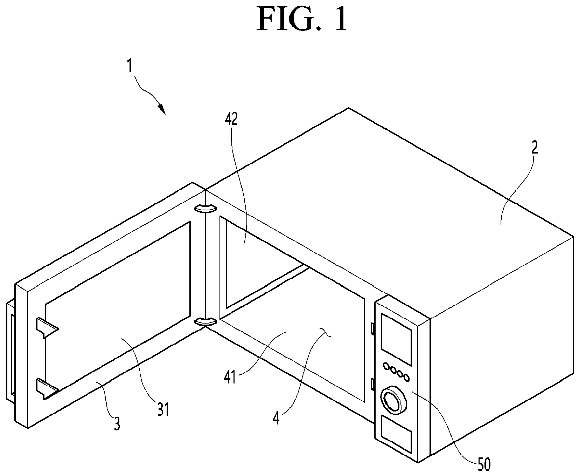

FIG. 1 is a perspective view of a cooking appliance 1 according to an embodiment of the present disclosure.

The cooking appliance 1 according to an embodiment of the present disclosure may include a housing 2 and a door 3 connected to the housing 2.

A cavity 4 may be formed in the housing 2. The cavity 4 may be a cooking chamber. The cavity 4 may be a cooking space where a load, that is, an object to be heated, is placed.

An input interface 50 may be formed on the outer surface of the housing 2. The input interface 50 may receive a user input for manipulating the cooking appliance 1.

The cavity 4 may be opened or closed by the door 3. The door 3 may be openably attached to the front portion of the housing 2. The door 3 may open and close the cavity 4.

A window 31 may be formed in the door 3. The user may check the inside of the cavity 4 through the window 31 when the cavity 4 is closed. The window 31 may include a window unit and a shielding unit.

The window unit may be formed of a transparent or a translucent material. The user may see the inside of the cavity 4 through the window unit.

The shielding unit may be mounted on the inner surface of the window unit. The shielding unit may block radio frequency (RF) from the cavity 4 from leaking out of the cooking appliance 1 through the door 3.

The shielding unit may be a wire mesh. A plurality of shielding holes may be defined in the shielding unit. The user may see the inside of the cavity 4 through the shielding hole, and RF does not pass through the shielding holes.

The cooking appliance according to an embodiment of the present disclosure may be an RF combination cooking appliance using RF heating, but the present disclosure is not limited thereto. Meanwhile, the RF combination cooking appliance may be an RF combination oven.

When cooking or defrosting the load, the cooking appliance according to the present disclosure may sense the load through at least one sensor, monitor sensing data in real time, and automatically control the operation of the cooking appliance.

The load may be food or an object to be heated, which is located within the cooking appliance and is heated or cooked by RF.

The at least one sensor may include a probe that is inserted into the load to acquire temperature data inside the load, an image sensor that acquires an image of the outer surface of the load, or a combination thereof. The image sensor may include a camera sensor. The cooking appliance may acquire, from the image of the outer surface of the load, data about the degree of searing of the outer surface of the load due to heating or cooking, that is, a searing value or brightness.

The cooking appliance 1 automatically ends cooking for the load when a set temperature is reached.

The cooking appliance 1 according to the present disclosure may not have a plate (e.g., a turntable) that assists uniform heating through the rotation of the load. The cooking appliance 1 may include at least one antenna for RF heating. However, the location or RF output direction of the at least one antenna in the cooking appliance 1 may be fixed. Therefore, since the load does not rotate in the cooking appliance 1, uniform heating is not easy.

Meanwhile, the cooking appliance 1 may calculate S11 (reflected wave/incident wave) through frequency scan and may heat the load by storing only the frequency that satisfies preset criteria, but accuracy may be low.

The cooking appliance 1 according to the present disclosure may collect and monitor sensing data about the load in real time by using at least one sensor (e.g., a temperature sensor such as a probe and/or an image sensor including a camera) . As described above, the sensing data about the load may be data about the internal temperature or external cooking level of the load.

The cooking appliance 1 may monitor temperature data for a specific location or a plurality of locations of the load in real time by using at least one sensor.

The cooking appliance 1 may variably control the RF frequency and output based on the temperature data for the load monitored in real time, external shearing value (e.g., brightness) of the load, etc. In this manner, the cooking appliance 1 according to the present disclosure may be more efficient than the conventional cooking appliance and may accurately and uniformly heat the load.

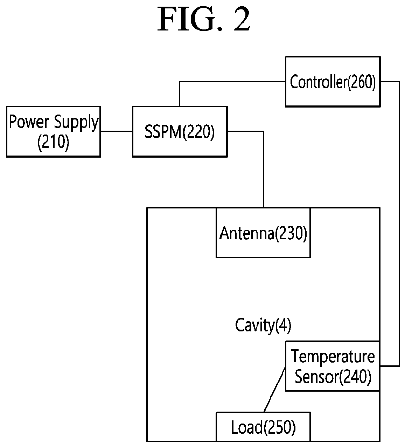

FIGS. 2 to 4 are control block diagrams of the cooking appliance 1 according to an embodiment of the present disclosure.

Referring to FIG. 2, the cooking appliance 1 may be configured to include a power supply 210, a solid-state power modulator (SSPM) 220, an antenna 230, a temperature sensor 240, and controller 260.

The power supply 210 may supply power such that the SSPM 220 operates. The power supply 210 may be a direct current (DC) power supply device.

The SSPM 220 may generate a desired heating frequency and RF output.

The RF output generated from the SSPM 220 may simultaneously penetrate through and directly heat the outside and inside of the load. Therefore, the temperature state of the load may be quickly controlled according to the RF output generated from the SSPM 220.

The cooking appliance 1 may heat food by oscillating one or more RF outputs from the SSPM 220, transmitting the RF outputs through a transmission line, and radiating the RF outputs to one or more multiple antennas inside the cooking chamber 4. That is, the cooking appliance 1 may perform accelerated heating control on the state of the load (e.g., temperature, etc.) by variably controlling the RF output oscillated from the SSPM 220.

Although not illustrated, the SSPM 220 may be configured to include at least one of a signal generator configured to generate an RF signal, a signal intensity controller configured to control the frequency output generated by the signal generator, a phase controller configured to change the phase of the signal whose intensity is controlled by the signal intensity controller, a signal amplifier configured to amplify the controlled phase signal, a DC power supply configured to supply power necessary for signal amplification, a signal output detector configured to detect the output in which the signal amplified by the signal amplifier is radiated in a forward direction and the output in the reverse direction in which the signal is reflected and returned, a signal transmitter configured to radiate the amplified signal from a heater cooking chamber 4, a protection circuit configured to protect important core elements and circuits from the output coming in the reverse direction due to reflected waves, or an integrated controller configured to generate and control the RF frequency. However, not all of the listed components may be required.

The SSPM 220 may implement one or more multiple RF output oscillator circuits into one integrated circuit and may generate and vary the RF frequency signal by controlling the signal generator through the integrated controller located inside the SSPM 220. Additionally, the signals generated by the signal generator may be applied to the signal intensity controller to vary the output of the RF signal. The phase of the signal applied from the signal intensity controller may be changed in the phase controller by the integrated controller.

The output signal amplified by the signal amplifier of the SSPM 220 may be radiated from the radiation antenna 230 of the signal transmitter to the cooking chamber 4. The forward and reverse outputs of the radiated RF signal may be detected by the signal transmitter. The heating state (temperature) of the load may be controlled by controlling the frequency, output, phase, etc. by comparing and analyzing the detected signals in the integrated controller. Additionally, the signal transmitter may protect the internal circuit from signals that are reflected inside the SSPM 220 and output in the reverse direction.

The antenna 230 may radiate the RF output generated by the SSPM 220 to the load 250 located in the cooking chamber (e.g., the cavity 4) through the transmission line.

The temperature sensor 240 may be inserted into the load 250 to measure the temperature inside the load 250.

The controller 260 can generally control the operation of the cooking appliance 1. The controller 260 may monitor temperature data measured for the load 250 by the temperature sensor 240 and may control the SSPM 220 to variably control the frequency and RF output.

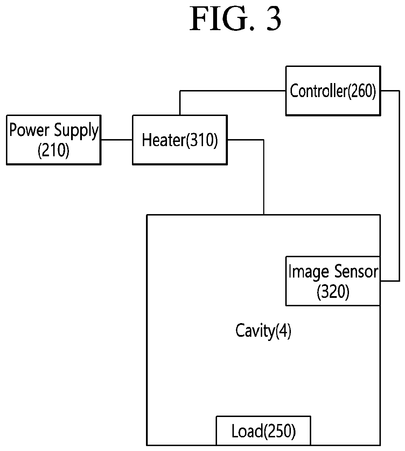

Referring to FIG. 3, the cooking appliance 1 may be configured to include a power supply 210, a heater 310, an image sensor 320, and a controller 260.

The power supply 210 may supply power such that the heater 310 operates. The power supply 210 may be a DC power supply device.

The heater 310 may generate heat for heating the load 250.

The image sensor 320 may acquire an image of the load 250 located within the cavity 4.

The controller 260 may acquire a brightness value for the outer surface of the load 250 from the image acquired by the image sensor 320, may control the heater 310 by monitoring the load 250, may variably control the output of the heater 310.

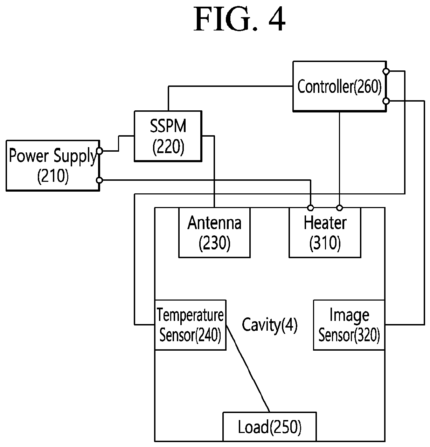

Referring to FIG. 4, the cooking appliance 1 may be configured to include a power supply 210, an SSPM 220, an antenna 230, a temperature sensor 240, a heater 310, an image sensor 320, and a controller 260.

FIG. 4 may be a combination of FIGS. 2 and 3. Therefore, the description of FIGS. 2 and 3 are equally applied to each component of FIG. 4, and redundant descriptions thereof are omitted.

However, since the function of the controller 260 is a combination of FIGS. 2 and 3, it will be described separately and may be as follows.

The controller 260 may monitor the load 250 by activating one or more of the temperature sensor 240 and the image sensor 320 and acquiring sensing data therefrom.

The controller 260 may control both the temperature sensor 240 and the image sensor 320 to be activated. In this case, the activation may be performed simultaneously or sequentially at intervals. In the latter case, for example, the controller 260 may activate the image sensor 320, and then, may further determine and control whether to activate the temperature sensor 240, based on the image analysis result acquired through the image sensor 320. The same is applied to the opposite case.

In FIGS. 2 and 4, only one SSPM 220 is illustrated, but a plurality of SSPMs 220 (e.g., for low frequency bands, for high frequency bands, etc.) may be provided according to the RF output or frequency band.

In FIGS. 2 and 4, only one antenna 230 is illustrated, but a plurality of antennas may be provided in the cavity 4. At this time, each antenna may be disposed at an appropriate position in consideration of the radiation direction or radiation angle such that the RF output generated by the SSPM 220 is uniformly radiated to the load 250.

According to embodiments, considering at least one of the size, shape, type, type, etc. of the load 250 to be placed in the cavity 4, at least one antenna 230 may be movable rather than fixed in position within the cavity 4, such that the RF output is well radiated to the load 250.

In FIGS. 3 and 4, only one heater 310 is illustrated, but a plurality of heaters, such as one heater 310 at the top of the cavity 4 and one heater 310 at the bottom of the cavity 4, may be provided. According to embodiments, the heater may be further provided on the side of the cavity 4.

The present disclosure relates to an electromagnetic wave-heat combination heating cooking appliance including an RF frequency heater and discloses a door structure including a shielding structure that prevents heat and electromagnetic waves generated in the cooking chamber from leaking out of the door.

The cooking appliance 1 is a product that cooks the load by using electromagnetic waves (RF) and/or high temperature heat through the SSPM 220 and/or the heater 310. However, problems may occur when high-temperature heat leaks out of the cooking appliance 1. Therefore, in the cooking appliance 1 according to the present disclosure, a component that prevents not only heat but also electromagnetic waves from escaping to the outside, that is, out of the cooking chamber, that is, a shielding member (e.g., a gasket) may be mounted between the door or the front surface of the cooking chamber (e.g., a front panel). At this time, the shielding member may be in contact with at least one surface of the door or the front panel.

However, this structure may cause a problem. For example, the door gap of the cooking appliance 1 increases compared to a conventional microwave oven (not shown). Typically, the door gap has increased to at least three times that of a microwave oven (e.g., 1.0 mm or less for a microwave oven and 3.0 mm or more for an oven). In other words, when a door choke structure employed in a conventional microwave oven is used in the cooking appliance 1 according to the present disclosure, it may be difficult to adequately shield electromagnetic wave leakage.

Therefore, in the present disclosure, electromagnetic wave leakage may be primarily shielded by applying a metal mesh structure to the outside of the heat shielding component, that is, the gasket, which is one of the factors causing the increase in the door gap. The present disclosure is not limited to the metal mesh structure outside the gasket.

In addition, in the present disclosure, additional shielding may be achieved through a door choke structure that includes a door frame including a choke and a choke cover according to the present disclosure, which will be described later.

Meanwhile, thermal damage to the choke cover may be prevented by preventing high-temperature heat in the cooking chamber from being emitted by the heat shielding gasket.

As described above, the present disclosure discloses a door choke that prevents electromagnetic waves from leaking out of the door in a built-in combination oven having a frequency heater. In the case of built-in combination cooking appliances compared to conventional microwave ovens, the door gap is 2-3 times larger. Accordingly, a plurality of door chokes have been used to reliably shield electromagnetic wave leakage. However, when using the plurality of door chokes, the door becomes thicker than necessary or the structure or composition of the door becomes complicated, which inevitably causes limitations in the design of the cooking appliance as well as difficult manufacturing processes and size management.

Hereinafter, in the present disclosure, one door choke (e.g., a single door choke) may be implemented in the door frame to solve the above problems.

In the present disclosure, in order to supplement or further improve the shielding performance according to the single door choke, a gasket used for heat shielding may be utilized. That is, the present disclosure aims to change the structure of the gasket while using a single door choke such that heat shielding and electromagnetic wave shielding are achieved together.

In the present disclosure, a metal mesh such as STS may be added to a gasket made of glass fiber on the outermost surface of a door. Accordingly, in the present disclosure, the structure of the gasket has a metal-to-metal structure, such that both heat shielding and electromagnetic wave leakage shielding may be performed.

Meanwhile, in the present disclosure, since the door gap increases due to the seating structure of the gasket, the front door frame may protrude into the cooking chamber to form a gap with the wall of the cooking chamber. In the present disclosure, heat and electromagnetic wave leakage that have occurred only through the gasket may be primarily shielded through this gap.

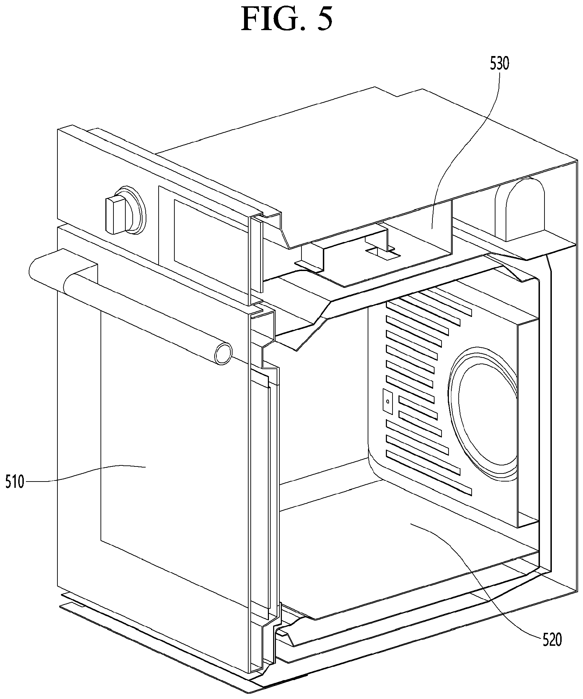

FIG. 5 is a cross-sectional view of the cooking appliance 1 according to an embodiment of the present disclosure.

Referring to FIG. 5, the cooking appliance 1 may include a door 510, a cooking chamber 520, and an electronic component chamber 530.

The door 510 may be configured to include a choke/porous mesh for electromagnetic wave shielding and glass/gasket for heat insulation.

The door 510 may be configured to reflect a shielding structure such that not only electromagnetic waves radiated from the electronic component chamber 530 to the load of the cooking chamber 520 but also heat generated by the heater do not leak out to the outside.

Meanwhile, the door 510 may include a window made of transparent glass such as ceramic glass. The window may be implemented in the form of a mesh plate (a porous mesh).

The cooking chamber 520 may be configured to include an antenna for heating the load, a top heater, and a convection device.

The cooking chamber 520 may have a shape that reflects an RF-compatible structure. The cooking chamber 520 may include a convection portion, a broil heater, an antenna, and at least one sensor.

The convection portion may include a convection cover and a motor. This convection portion may be mounted inside the cooking chamber or have a wide cover type chamber structure. Meanwhile, in the convection portion, a mesh for shielding the fan and the motor may be applied. However, the present disclosure is not limited thereto.

The broil heater may be controlled through a camera.

The antenna may be controlled through a voltage standing wave ratio (VSWR), a temperature detection sensor, etc.

The electronic component chamber 530 may be configured to include an RF generator, a heating source controller, cooling and power, etc.

The electronic component chamber 530 may include a control circuit printed circuit board (PCB) and RF major components (particularly cooling-related components) such as an SSPM/switched-mode power supply (SMPS) and RF feeding unit, a heat sinks, and a fan.

However, according to embodiments, the configuration or structure of FIG. 5 may be different from that illustrated herein.

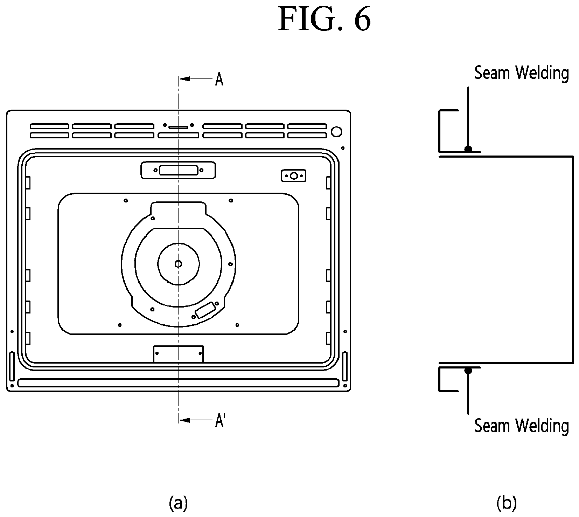

FIG. 6 is a configuration diagram of the cooking chamber 520 according to an embodiment of the present disclosure.

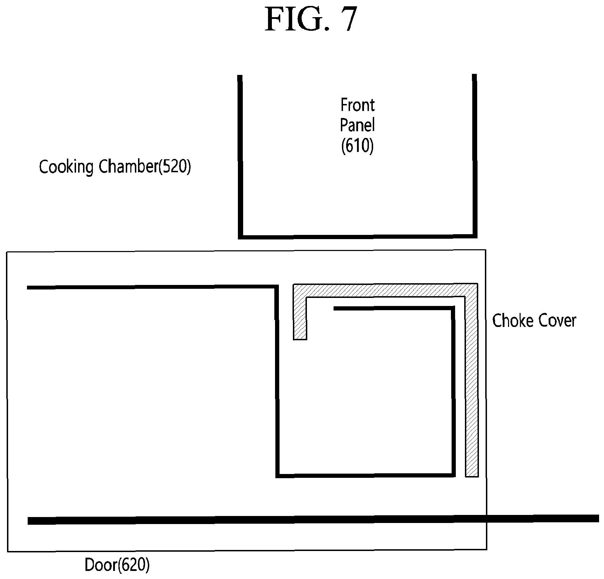

FIG. 7 is a diagram illustrating the door choke structure.

(a) of FIG. 6 is a view of the cooking appliance 1 when viewed from the front.

(b) of FIG. 6 is a cross-sectional view when viewed from A-A' in FIG. (a) of FIG. 6.

Referring to (b) of FIG. 6, the cooking chamber 520 may differ depending on the manufacturing method, but may largely include a front panel facing the door and the top, bottom, side, and back surfaces of the cooking chamber. Meanwhile, in the case of the built-in cooking appliance, the front panel has an opening in the front of the cooking chamber and may have a bent shape (grille) for fitting and fixing a drawer.

Referring to (b) of FIG. 6, seam welding may be performed between the front and the inner plate. However, the present disclosure is not limited thereto.

The door choke structure is described below with reference to FIG. 7.

The door choke may be configured to shield electromagnetic waves (possibly heat).

The door choke may operate as an LC filter within a desired frequency band by a front panel 610 of the cooking chamber 520 and a door choke structure of a door 620 facing the front panel 610.

Accordingly, even if a gap exists between the door 620 and the front panel 610 when the door is closed, the door choke has an impedance of zero within a given electromagnetic wave band, thereby allowing electromagnetic waves to be reflected without leaking to the outside of the cooking appliance 1.

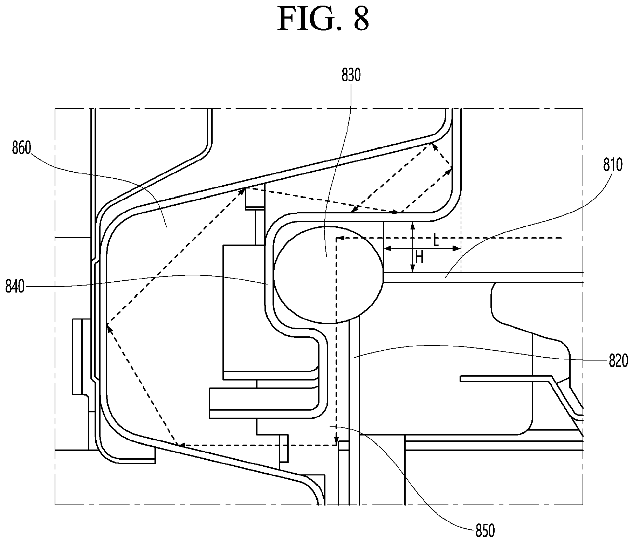

FIG. 8 is a diagram illustrating a door choke structure according to an embodiment of the present disclosure.

The cooking appliance according to an embodiment of the present disclosure may include a cooking chamber 520 where a load is located, a front panel 810 located at one end of the cooking chamber 520 and whose portion is bent, and a door that shields heat and electromagnetic waves.

The door may include a door frame including a single door choke. The door may include glass. The door may include a plate including a porous mesh. The door may include a choke cover.

The door may include or be combined with a shielding member, that is, a gasket. For convenience of explanation, the gasket is located between the front panel and the door and is described as being mounted on the door.

The gasket according to the present disclosure may be disposed between the front panel and the door and may shield heat/electromagnetic waves leaking from the cooking chamber toward the outside of the cooking appliance 1.

A metal mesh may be added to the gasket according to the present disclosure. At this time, the metal mesh may surround the entire surface or outer surface while facing at least the cooking chamber. In this manner, the gasket according to the present disclosure may perform both the heat shielding function and the electromagnetic wave shielding function. In addition, this metal mesh may also perform the function of preventing overheating of the choke cover, which will be described later.

In the present disclosure, the gasket 830 may have a circular (or oval) shape, but is not limited thereto.

The gasket 830 according to the present disclosure may have a perimeter according to a predefined radius (or diameter).

The gasket according to the present disclosure may be a member formed of an elastic material. As illustrated in FIG. 8, a portion where one end of the gasket is in contact with the front panel may be in complete contact with the front panel due to pressure. Therefore, there may be no gap, thereby preventing heat from leaking. Meanwhile, according to embodiments, the front panel, not the gasket, is a member of an elastic material. As described above, the shape is deformed by pressure to accommodate the gasket and there is no gap therebetween, thereby preventing heat from the cooking chamber from leaking to the outside. In addition to the heat described above, electromagnetic waves may also be shielded in the same way when the metal mesh is mounted on the gasket.

The door choke structure according to the present disclosure will be described with reference to FIG. 8.

Referring to FIG. 8, the choke structure may extend a portion facing the choke from the front panel to the inner wall of the cooking chamber in order to minimize electromagnetic wave leakage and increase the cover bandwidth.

As described above, the metal-to-metal structure may be formed between the choke piece and the front panel/the interior wall of the cooking chamber by increasing the choke structure according to the present disclosure and applying a structure that surrounds the outside of the gasket used for heat shielding with the metal mesh, thereby further improving electromagnetic wave shielding performance.

Meanwhile, in the present disclosure, a choke cover made of heat-resistant rubber may be configured for protecting the appearance of the choke.

As described above, the door frame may protrude toward the cooking chamber to form a door gap.

The door frame may protrude toward the cooking chamber 520 by a length smaller than the circumference of the gasket. The door frame may protrude toward the cooking chamber 520 by a length greater than the radius of the gasket. The door frame may protrude toward the cooking chamber 520 by a length larger than the radius of the gasket and smaller than the circumference.

The height and length of the door gap may be determined considering at least one of heat or electromagnetic waves used to heat the load in the cooking chamber.

The door gap may be smaller than the diameter of the gasket and may be equal to or larger than the radius.

The choke piece may be located on the front side of the front panel.

The choke piece may be formed along the outer circumferential surface of the gasket. In this manner, the choke piece may support the gasket. The choke piece may accommodate the gasket and apply pressure to the gasket in the direction of the cooking chamber to minimize the gap between the gasket and the front panel, thereby contributing to blocking heat and electromagnetic waves.

The choke piece 840 may have a plurality of bent portions. The number of bent portions of the choke piece may be determined according to the shape of the gasket.

In FIG. 8, the surface of the choke piece accommodating the gasket may not be in complete contact with the gasket 830 on all surfaces.

Referring to FIG. 8, the choke piece space where the gasket 830 is accommodated, rather than the portion of the gasket exposed to the cooking chamber 520, accommodates and supports the entire gasket, but it may be sufficient if it is in contact with one surface (or one point) of the gasket. As described above, this may be to apply pressure through the choke piece such that the gasket comes into contact with the front panel formed toward the cooking chamber, that is, on the inner wall of the cooking chamber.

In the cooking appliance 1 according to the present disclosure, a choke base with a predetermined space may be formed on the outer circumferential surface of the choke cover and the choke piece.

The choke base may include a plurality of bent portions.

The choke base may have a shape that becomes narrower in the opposite direction rather than in the direction of the cooking chamber 520. To this end, a plurality of bent portions may be formed in the choke base.

At least one of the size, volume, or shape of the choke base space may vary depending on the operating frequency of the cooking appliance 1.

The door may have a choke structure shape determined depending on the frequency of the electromagnetic waves through the single door choke.

In the present disclosure, heat and electromagnetic waves may be primarily blocked through the gasket, heat and electromagnetic waves may be secondarily blocked through the choke cover, and heat and electromagnetic waves may be tertiarily blocked through the choke base.

The choke may include a choke piece that has at least one surface protruding to be exposed to the cooking chamber, forms the door gap through a first bent portion, and accommodates a shielding member through second to fourth bent portions.

The choke cover may be formed of an elastic material. The choke cover may be disposed between the fourth bent portion of the choke piece and one surface of the front panel. The choke cover may be in contact with one surface of the shielding member to support the shielding member.

The width between the fourth bent portion of the choke piece and one surface of the front panel may be smaller than the height of the door gap.

The choke may further include a first choke base that is disposed between the outer circumferential surface of the choke piece, the outer surface of the choke cover, and the cover of the door, and has a space to receive and shield at least one of heat or electromagnetic waves passing through the choke cover.

The first choke base 850 may include a plurality of bent portions. The first choke base may be formed to have an arbitrary angle such that heat and electromagnetic waves incident through the choke cover and the plurality of bent portions are reflected.

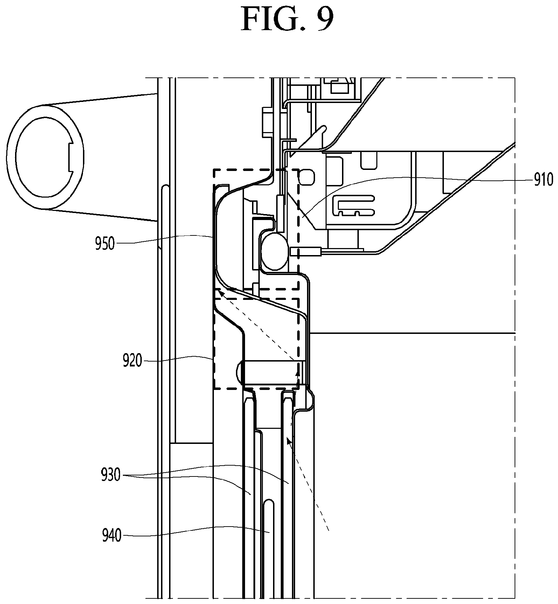

FIG. 9 is a diagram illustrating a front panel according to an embodiment of the present disclosure.

The door may further include a second choke base 920 that receives and shields at least one of heat or electromagnetic waves generated in the cooking chamber through glass disposed in the front of the cooking chamber.

The second choke base 920 may have a space formed by a plurality of bent portions so as to induce and reflect at least one of heat or electromagnetic waves incident on the space defined therein.

Referring to FIG. 9, the first choke base 950 may be in contact with at least a portion of the second choke base 920. For example, the outer surface of the first choke base 950 may be the inner surface of the second choke base 920.

Unlike FIG. 8, in FIG. 9, the door may include a porous mesh cover, glass, a choke base, a platform assembly, and a porous mesh cover.

In FIG. 9, the gasket may be in contact with the float panel on at least two sides. As described above, a choke piece having a plurality of bent portions may be formed on the outer circumferential surface of the gasket. However, unlike as illustrated in FIG. 8, the choke piece may be directly exposed to the cooking chamber. In other words, the choke piece may directly reflect electromagnetic waves. Heat may be blocked from leaking through the gasket.

Meanwhile, as illustrated in FIG. 9, electromagnetic waves (and heat) generated in the cooking chamber may be guided in a predetermined direction through the glass when incident.

Electromagnetic waves induced in this way may be absorbed or reflected through the porous mesh cover and glass.

Meanwhile, the incident electromagnetic waves (and heat) enter through a path guided by the glass, but may be further induced according to the choke base with the bent portions.

Electromagnetic waves further induced by the choke base may enter the gap formed by the platform assembly and the porous mesh cover and may be reflected back. At this time, an elastic metal may be inserted into the gap between the platform assembly and the porous mesh cover. Accordingly, the gap described above may be arbitrarily adjusted.

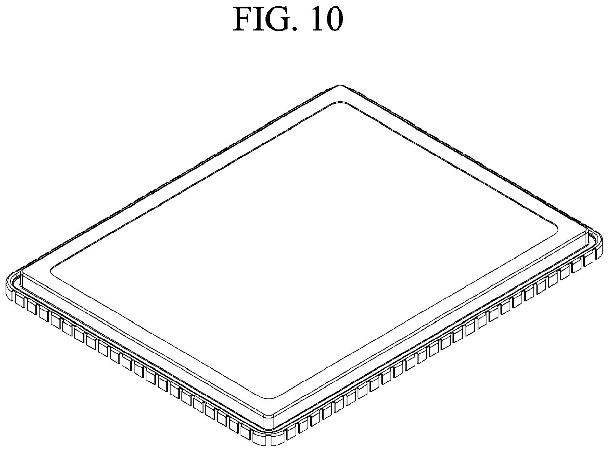

FIG. 10 is a diagram illustrating a slat according to an embodiment of the present disclosure.

The periodic structure of the choke according to the present disclosure may be designed as a slat structure in which grooves are formed at regular intervals, as illustrated in FIG. 10. However, the present disclosure is not limited thereto. That is, spacing, grooves, etc. may be designed differently from those illustrated in the drawings.

The length of the choke may be modified depending on the operating frequency of the cooking appliance 1.

The width of the slat may be modified depending on the operating frequency of the cooking appliance 1.

The length of the choke and the width of the slat may be modified depending on the operating frequency of the cooking appliance 1.

The operating frequency of the cooking appliance 1 may be modified depending on the length of the choke.

The operating frequency of the cooking appliance 1 may be modified depending on the width of the slat.

The operating frequency of the cooking appliance 1 may be modified depending on the length of the choke and the width of the slat.

The choke may be miniaturized according to the present disclosure, and the thickness of the cooking appliance 1 in which electromagnetic waves are additionally used as a heat source may be reduced through performance stability.

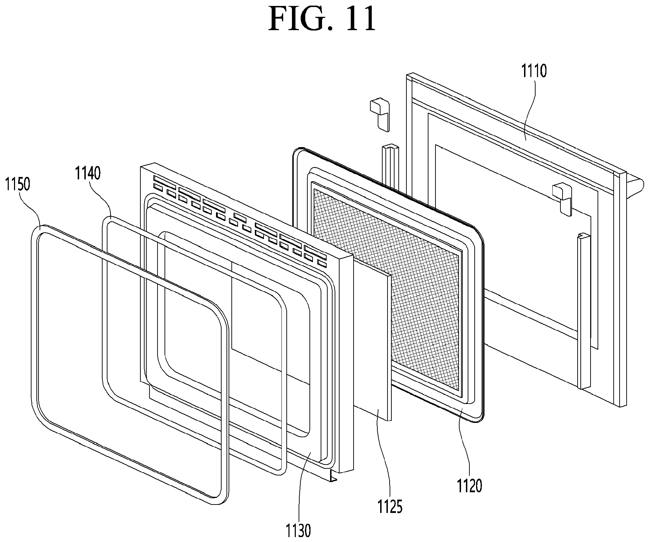

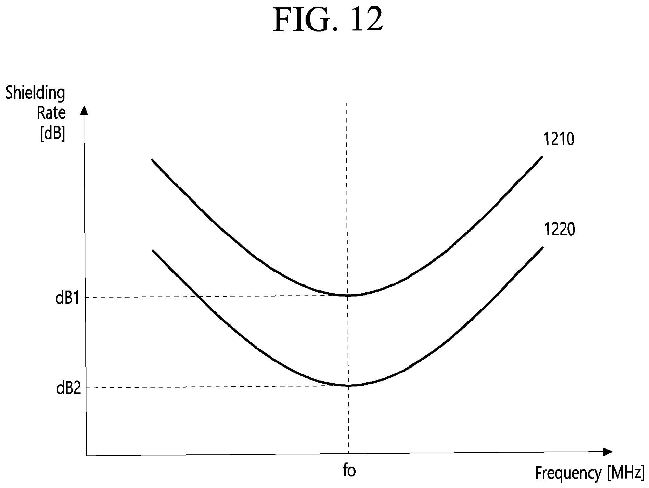

FIGS. 11 and 12 are diagrams for describing the door structure or configuration according to an embodiment of the present disclosure.

FIG. 11 illustrates an example of the structure or configuration of the door according to an embodiment of the present disclosure.

Referring to FIG. 11, the door according to the present disclosure may provide both heat shielding and electromagnetic wave shielding even though the same components and space as those of the conventional cooking appliance are used to maintain the door thickness and cooking chamber capacity of the conventional cooking appliance.

The cooking appliance 1 may include a cooking chamber where a load is located, a front panel located at one end of the cooking chamber, and having a bent portion, and a door that shields heat and electromagnetic waves.

In particular, referring to FIG. 11, the door may include a cover assembly door including a handle.

The door may include a rocker assembly formed at one end of the cover assembly door.

The door may include an inner portion 1120 including a mesh plate for electromagnetic wave shielding at the rear surface of the cover assembly door.

The door may include an inner glass 1125 of a glass (e.g., double-layer) structure that is mounted on the rear surface of the inner portion and blocks heat.

The door may include a frame assembly door 1130 including a choke structure for electromagnetic wave shielding on the rear surface of the inner glass.

The door may include a gasket packing 1140 that is mounted on the rear surface of the frame assembly door 1130 and shields heat and electromagnetic wave leakage when the door is closed.

The door may include a choke cover 1150 that covers the gasket packing 1140 and has a slat shape.

The door may be configured to include a plurality of the components described above.

Referring to FIG. 12, it can be seen that the choke has the highest shielding performance at the design frequency depending on the frequency characteristics of the choke and has characteristics that decrease left and right with respect to the frequency (fo).

The combination cooking appliance with electromagnetic wave heating according to the present disclosure is described as including the front panel with the curved left and right outer edges having a structure suitable for the size of the drawer, the cooking chamber attached thereto, and the door.

The door may be configured to include a door frame including a choke, glass, a plate including a porous mesh, a choke cover, a gasket, etc., and may shield heat and electromagnetic waves together (or simultaneously).

According to the present disclosure, one choke for preventing electromagnetic wave leakage, that is, a single choke, is configured such that the front panel and the inner wall of the cooking chamber face each other to secure maximum shielding performance in a limited space.

To this end, in the present disclosure, the structure bent at least once and the slot structure may be applied to form the choke in a limited space.

The periodic slots may not be applied to the side not covered by the choke cover. The portion where the periodic slots are applied and the choke opening may be covered with the choke cover.

Heat and electromagnetic wave leakage may be shielded by covering the outermost portion of the gasket, which is used to prevent heat leakage from the cooking chamber, with the metal mesh.

In addition, the choke cover made of high-temperature rubber may serve to primarily block heat at high temperatures to prevent damage caused by heat.

In the present disclosure, since the end face of the gasket is in contact with the front panel, the choke cover does not come into contact with the high temperature front panel, thereby preventing thermal damage due to contact.

In the present disclosure, the gasket and the choke cover may be seated on the frame assembly toward the inside of the cooking chamber. Meanwhile, the glass for heat blocking may be placed outside the cooking chamber, and the porous mesh cover may be placed behind the glass to shield electromagnetic wave leakage.

Therefore, according to the present disclosure, even if electromagnetic waves pass through the glass, electromagnetic wave leakage is shielded by the porous mesh. Since leakage may occur in the gap between the frame assembly and the porous mesh cover, electromagnetic wave leakage into the gap may be additionally shielded by inserting an elastic metal therebetween.

In the present disclosure, shielding may refer to preventing electromagnetic waves from leaking to the outside of the cooking appliance 1 through reflection, absorption, etc.

According to at least one of various embodiments of the present disclosure, there is an effect of automatically controlling cooking by monitoring the load in real time.

According to at least one of various embodiments of the present disclosure, there is an effect of variably controlling the frequency and output of the heat source according to the load.

According to at least one of various embodiments of the present disclosure, there is an effect of enabling more accurate and uniform heating of the load.

In addition to the above-described effects, specific effects of the present disclosure will be described together while explaining specific details.

The above description is merely illustrative of the technical spirit of the present disclosure, and various modifications and changes can be made by those of ordinary skill in the art, without departing from the scope of the present disclosure.

Therefore, the embodiments disclosed in the present disclosure are not intended to limit the technical spirit of the present disclosure, but are intended to explain the technical spirit of the present disclosure. The scope of the technical spirit of the present disclosure is not limited by these embodiments.

The scope of the present disclosure should be interpreted by the appended claims, and all technical ideas within the scope equivalent thereto should be construed as falling within the scope of the present disclosure.

### [Description of Symbols]

- 1:: cooking appliance
- 2:: housing
- 3:: door
- 4:: cavity

## Claims

1. A cooking appliance (1) comprising:
a cooking chamber (520) where a load is located;
a front panel (620) located at one end of the cooking chamber (520) and having a bent portion; and
a door (620) having a structure configured to shield heat and electromagnetic waves generated in the cooking chamber, wherein the door (620) comprises a door frame including a choke and a choke cover, wherein a shielding member is disposed between the front panel and the door (620), and wherein the shielding member is in contact with at least one surface of the front panel and the door (620) .

2. The cooking appliance (1) of claim 1, wherein the door frame comprises a door gap protruding toward the cooking chamber (520) .

3. The cooking appliance (1) of claim 2, wherein a height and a length of the door gap are associated with at least one of a size or elasticity of the shielding member.

4. The cooking appliance (1) of claim 2 or 3, wherein a height and a length of the door gap is in accordance with at least one of heat or electromagnetic waves used to heat the load in the cooking chamber.

5. The cooking appliance (1) of any one of claims 2 to 4, wherein the choke comprises a choke piece that has at least one surface protruding to be exposed to the cooking chamber (520), configured to form the door gap through a first bent portion, and configured to accommodate the shielding member through second to fourth bent portions.

6. The cooking appliance (1) of claim 5, wherein the choke cover is formed of an elastic material, is disposed between the fourth bent portion of the choke piece and one surface of the front panel, and is in contact with one surface of the shielding member configured to support the shielding member.

7. The cooking appliance (1) of claim 5 or 6, wherein a width between the fourth bent portion of the choke piece and one surface of the front panel is smaller than the height of the door gap.

8. The cooking appliance (1) of any one of claims 5 to 7, wherein the choke further comprises a first choke base that is disposed between an outer circumferential surface of the choke piece, an outer surface of the choke cover, and a cover of the door, and has a space configured to receive and shield at least one of heat or electromagnetic waves passing through the choke cover.

9. The cooking appliance (1) of claim 8, wherein the first choke base comprises a plurality of bent portions and is formed to have an arbitrary angle configured to reflect heat and electromagnetic waves incident through the choke cover and the plurality of bent portions.

10. The cooking appliance (1) of claim 8 or 9, wherein the door (620) further comprises a second choke base configured to receive and shield at least one of heat or electromagnetic waves generated in the cooking chamber (520) through glass disposed in front of the cooking chamber, and wherein the second choke base has a space formed by a plurality of bent portions configured to induce and reflect at least one of heat or electromagnetic waves incident on the space defined therein.

11. The cooking appliance (1) of claim 10, wherein the first choke base is in contact with at least a portion of the second choke base.

12. The cooking appliance (1) of any one of claims 1 to 11, wherein a periodic structure of the choke is designed as a slat structure in which grooves are formed at regular intervals, and wherein a length of the choke and a width of the slat are configured to be modified according to a frequency of the electromagnetic waves.

13. The cooking appliance of any one of claims 1 to 12, wherein the shielding member is formed of a circular, elastic material, and an outer circumference of the shielding member is covered with a metal mesh.

14. A cooking appliance (1) comprising:
a cooking chamber (520) where a load is located;
a front panel (610) located at one end of the cooking chamber (520) and having a bent portion; and
a door (620) configured to shield heat and electromagnetic waves,
wherein the door (620) comprises:
a cover assembly door comprising a handle;
an inner portion including a mesh plate configured to shield electromagnetic waves at a rear surface of the cover assembly door;
a frame assembly door including a choke structure configured to shield electromagnetic waves on a rear surface of an inner glass of a glass structure that is mounted on a rear surface of the inner portion and is configured to block heat;
a gasket packing that is mounted on a rear surface of the frame assembly door and is configured to shield heat and electromagnetic wave leakage when the door is closed; and
a choke cover configured to cover the gasket packing and has a slat shape.
